# EUROPEAN PATENT SPECIFICATION

(11) **EP 3 270 499 B1**
(45) Date of publication and mention of the grant of the patent: **29.04.2020**
(21) Application number: 17175343.7
(22) Date of filing: 09.06.2017
(51) Int. Cl.: H02M 7/00, H05K 7/14

(54) **POWER CONVERSION DEVICE**
STROMWANDLUNGSVORRICHTUNG
DISPOSITIF DE CONVERSION D'ALIMENTATION ÉLECTRIQUE

(30) Priority: 15.07.2016 CN 201610559575
(43) Date of publication of application: 17.01.2018
(73) Proprietor: Delta Electronics (Shanghai) Co., Ltd., 201209 Shanghai (CN)
(72) Inventor: Ren, Xiang, Pudong, Shanghai 201209 (CN); Qian, Feng, Pudong, Shanghai 201209 (CN); Chen, Jun, Pudong, Shanghai 201209 (CN); Kuang, Jing-Xian, Pudong, Shanghai 201209 (CN); Lu, Yan-Song, Pudong, Shanghai 201209 (CN)
(74) Representative: Nederlandsch Octrooibureau

(56) References cited:
- EP-A2- 2 677 646
- JP-A- H0 847 268
- US-A1- 2004 228 094
- US-A1- 2012 170 175
- US-A1- 2014 036 418
- US-A1- 2015 229 246

## Description

### BACKGROUND

### Field of Invention

The present disclosure relates to a power source conversion device. More particularly, the present disclosure relates to power conversion device.

### Description of Related Art

With the rapid development of power electronics technology, high-power power conversion devices have gradually gained attention and have flourished. However, consequently, the power modules in the power conversion devices must meet more stringent design specifications to support high-power applications. A common power module typically has a direct current (DC) bus capacitor, and the DC bus capacitor is primarily used for carrying a DC bus voltage, as well as absorbing an alternating current (AC) current component to prevent the AC current component from generating an excessively high voltage component on the DC bus. However, as the power supported by the power electronics devices becomes increasingly greater, the amount of AC current passing the DC bus capacitor also increases. As a result, the temperature of the DC bus capacitor rises, thereby increasing the loss of the DC bus capacitor and shortening its lifetime.

For the foregoing reasons, there is a need to attend both the high-power application and protection of DC bus capacitor by providing a power conversion device.

US 2004/228094 A1, US 2015/229246 A1, JP H08 47268 A, US 2012/170175 A1, EP 2 677 646 A2, and US 2014/036418 A1 all disclose prior art power conversion devices. Especially, US 2015/229246 A1 discloses a power conversion device having a power module comprising first, second and third power units, each having first, second and third DC buses, respectively, and first, second and third connection devices disposed on the first, second and third DC buses, respectively; a first connection bus electrically connected to the first DC bus of the first power unit and the second DC bus of the second power unit, and electrically connected to the first connection device and the second connection device; and a second connection bus electrically connected to the second DC bus of the second power unit and the third DC bus of the third power unit, and electrically connected to the second connection device and the third connection device.

### SUMMARY

The present disclosure provides a power conversion device according to claim 1. The power conversion device comprises a rectifier module, an inverter module, and a first interconnection bus. The rectifier module is configured to convert an AC power source into a DC power source, and the rectifier module comprises a first rectifier power unit, a second rectifier power unit, a third rectifier power unit, a first connection bus, and a second connection bus. The first connection bus is electrically connected to the first rectifier power unit and the second rectifier power unit. The second connection bus is electrically connected to the second rectifier power unit and the third rectifier power unit. The inverter module is configured to convert a DC power source into an AC power source, and the inverter module comprises a first inverter power unit, a second inverter power unit, a third inverter power unit, a third connection bus, and a fourth connection bus. The third connection bus is electrically connected to the first inverter power unit and the second inverter power unit. The fourth connection bus is electrically connected to the second inverter power unit and the third inverter power unit. The first interconnection bus is configured to connect the rectifier module and the inverter module, and the rectifier module is symmetrical with the inverter module through the first interconnection bus.

In summary, the technical solution of the present disclosure has obvious advantages and beneficial effects as compared with the prior art. Through the above technical solution, considerable advances in technology and extensive industrial applicability can be achieved. The power conversion device disclosed by the present disclosure first utilizes different connection buses to respectively connect the rectifier power units in the rectifier module(s) and the inverter power units in the inverter module(s), and then utilizes the interconnection bus(es) to connect the rectifier module(s) and the inverter module(s). In this manner, mutual effects between the DC bus capacitors in the rectifier module(s) and the DC bus capacitors in the inverter module(s) can be decoupled to decrease the current(s) passing the DC bus capacitors.

It is to be understood that both the foregoing general description and the following detailed description are by examples, and are intended to provide further explanation of the invention as claimed.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention. In the drawings,
Fig. 1A depicts a block diagram of a power conversion device according to one embodiment of the present disclosure;
Fig. 1B depicts a three-dimensional schematic diagram of the power conversion device in Fig. 1A according to one embodiment of the present disclosure;
Fig. 2A and Fig. 2B depict circuit diagrams of power units in a power module according to one embodiment of the present disclosure;
Fig. 3 depicts a block diagram of a power conversion device according to another embodiment of the present disclosure;
Fig. 4A depicts a block diagram of a power conversion device according to still another embodiment of the present disclosure;
Fig. 4B depicts a three-dimensional schematic diagram of the power conversion device in Fig. 4A according to still another embodiment of the present disclosure;
Fig. 4C depicts a circuit diagram of a magnetic ring in a power conversion device according to one embodiment of the present disclosure;
Fig. 5A depicts a block diagram of a power conversion device according to yet another embodiment of the present disclosure; and
Fig. 5B depicts a three-dimensional schematic diagram of the power conversion device in Fig. 5A according to yet another embodiment of the present disclosure.

### DESCRIPTION OF THE EMBODIMENTS

Reference will now be made in detail to embodiments of the present disclosure, examples of which are described herein and illustrated in the accompanying drawings. While the disclosure will be described in conjunction with embodiments, it will be understood that they are not intended to limit the disclosure to these embodiments. Description of the operation does not intend to limit the operation sequence. Any structures resulting from recombination of devices with equivalent effects are within the scope of the present disclosure. It is noted that, in accordance with the standard practice in the industry, the drawings are only used for understanding and are not drawn to scale. Hence, the drawings are not meant to limit the actual embodiments of the present disclosure. In fact, the dimensions of the various features may be arbitrarily increased or reduced for clarity of discussion. Wherever possible, the same reference numbers are used in the drawings and the description to refer to the same or like parts for better understanding.

Terms used throughout the specification and the claims typically have common meanings for each of the terms used in this field, in the present disclosure and in special contents, unless specially noted. Some terms for describing the present disclosure will be discussed in the following or elsewhere in this specification for providing practitioners with additional guidance related to the description of the present disclosure.

Furthermore, it should be understood that the terms, "comprising", "including", "having", "containing", "involving" and the like, used herein are open-ended, that is, including but not limited to. It will be understood that, as used herein, the phrase "and/or" includes any and all combinations of one or more of the associated listed items.

In this document, the term "coupled" may also be termed "electrically coupled," and the term "connected" may be termed "electrically connected." "Coupled" and "connected" may also be used to indicate that two or more elements cooperate or interact with each other. It will be understood that, although the terms "first," "second," etc., may be used herein to describe various elements, they are merely used to distinguish the devices or operations described with the same technical terms. Unless otherwise specified, these terms do not refer to or imply the order or priority, nor are they intended to limit the present disclosure.

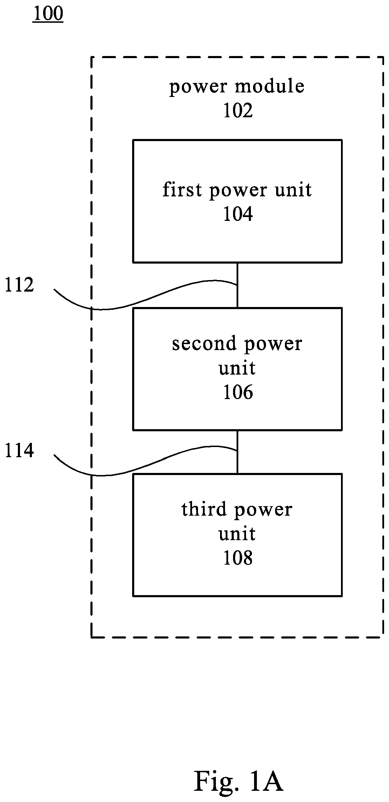

Fig. 1A depicts a block diagram of a power conversion device 100 according to one embodiment of the present disclosure. As shown in Fig. 1A, the power conversion device 100 comprises a power module 102, and the power module 102 comprises a first power unit 104, a second power unit 106, a third power unit 108, a first connection bus 112, and a second connection bus 114. The first connection bus 112 is electrically connected to the first power unit 104 and the second power unit 106. The second connection bus 114 is electrically connected to the second power unit 106 and the third power unit 108.

In one embodiment, the first power unit 104 comprises a first DC bus. The second power unit 106 comprises a second DC bus. The third power unit 108 comprises a third DC bus. The first connection bus 112 is electrically connected to the first DC bus in the first power unit 104 and the second DC bus in the second power unit 106. The second connection bus 114 is electrically connected to the second DC bus in the second power unit 106 and the third DC bus in the third power unit 108.

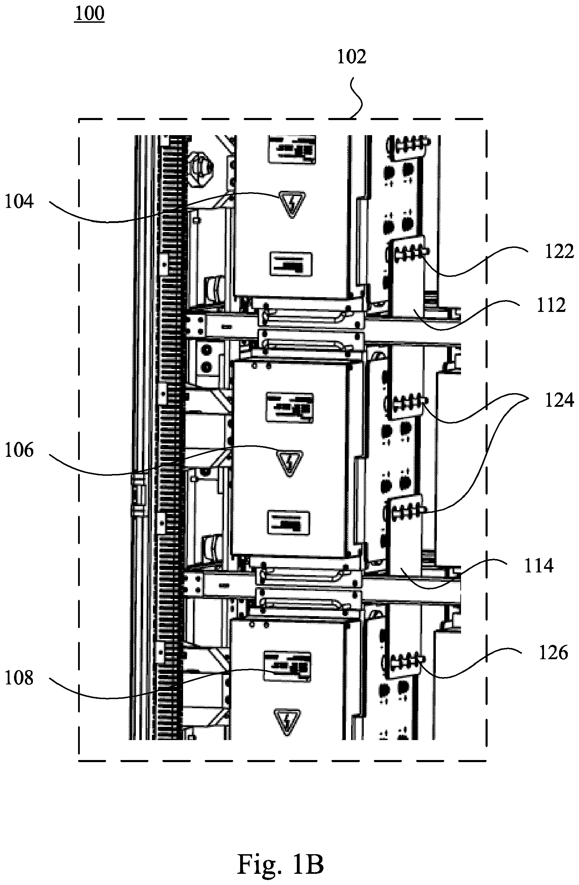

Fig. 1B depicts a three-dimensional schematic diagram of the power conversion device 100 in Fig. 1A according to one embodiment of the present disclosure. As shown in Fig. 1B, the power module 102 in the power conversion device 100 further comprises a first connection device 122, a second connection device 124, and a third connection device 126. The first connection device 122 is disposed on the first DC bus of the first power unit 104. The second connection device 124 is disposed on the second DC bus of the second power unit 106. The third connection device 126 is disposed on the third DC bus of the third power unit 108. The first connection bus 112 is electrically connected to the first connection device 122 and the second connection device 124. The second connection bus 114 is electrically connected to the second connection device 124 and the third connection device 126. In other words, the first power unit 104, the second power unit 106, and the third power unit 108 can be connected to one another through the first connection device 122, the second connection device 124, the third connection device 126, the first connection bus 112, and the second connection bus 114. For example, each of the first connection device 122, the second connection device 124, and the third connection device 126 may be a stud or a connecting lug.

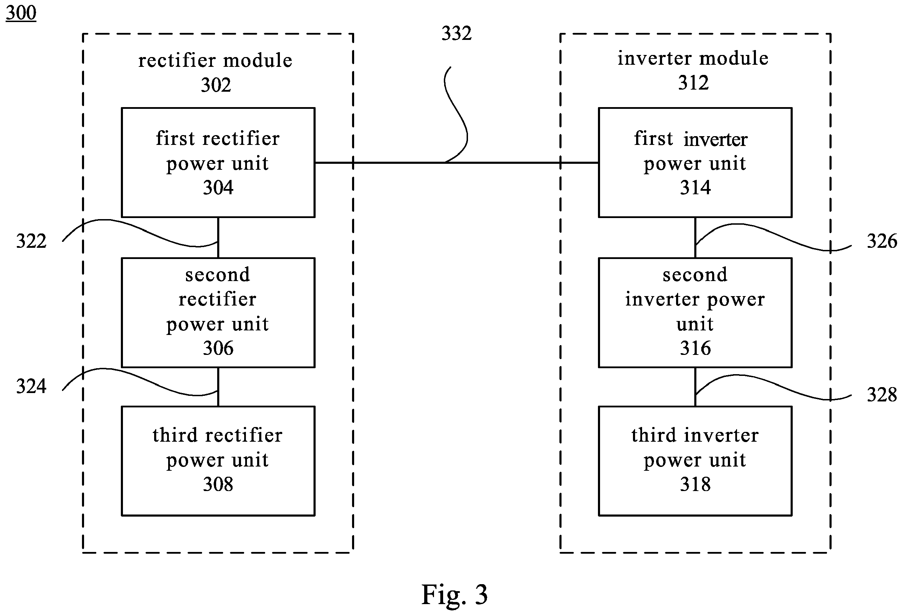

In one embodiment, the power module 102 may be a rectifier module (such as a rectifier module 302 in Fig. 3), and is configured to convert an AC power source into a DC power source. When the power module 102 is a rectifier module, the first power unit 104 is a first rectifier power unit (such as a first rectifier power unit 304 in Fig. 3), the second power unit 106 is a second rectifier power unit (such as a second rectifier power unit 306 in Fig. 3), and the third power unit 108 is a third rectifier power unit (such as a third rectifier power unit 308 in Fig. 3).

In another embodiment, the power module 102 may be an inverter module (such as an inverter module 312 in Fig. 3), and is configured to covert a DC power source into an AC power source. When the power module 102 is an inverter module, the first power unit 104 is an inverter module, the first power unit 104 is a first inverter power unit (such as a first inverter power unit 314 in Fig. 3). The second power unit 106 is a second inverter power unit (such as a second inverter power unit 316 in Fig. 3). The third power unit 108 is a third inverter power unit (such as a third inverter power unit 318 in Fig. 3).

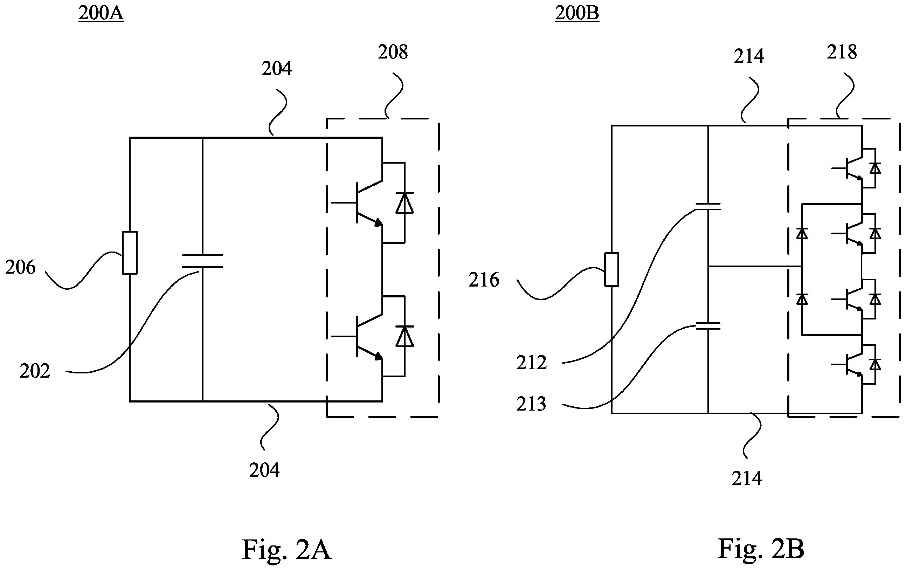

Fig. 2A and Fig. 2B depict circuit diagrams of power units in the power module 102 according to one embodiment of the present disclosure. As shown in Fig. 2A and Fig. 2B, each of a first power unit 104, a second power unit 106, and a third power unit 108 comprises a single-arm bridge power unit. The single-arm bridge power unit may be a two-level power unit or a multi-level power unit. A description is provided with reference to Fig. 2A. For example, the first power unit 104, the second power unit 106, and the third power unit 108 are single-arm bridge two-level power units 200A. The power unit 200A comprises a DC bus capacitor 202, a DC bus 204, a discharge resistor 206, and a switch unit 208. The DC bus 204 is electrically connected to the DC bus capacitor 202, the discharge resistor 206, and the switch unit 208, and the DC bus capacitor 202, the discharge resistor 206, and the switch unit 208 are connected in parallel. A description is provided with reference to Fig. 2B. The first power unit 104, the second power unit 106, and the third power unit 108 are single-arm bridge three-level power units 200B. The power unit 200B comprises a first DC bus capacitor 212, a second DC bus capacitor 213, a DC bus 214, a discharge resistor 216, and a switch unit 218. The DC bus 214 is electrically connected to the first DC bus capacitor 212, the second DC bus capacitor 213, the discharge resistor 216, and the switch unit 218. The first DC bus capacitor 212 and the second DC bus capacitor 213 are connected in series, and a series structure formed by the first DC bus capacitor 212 and the second DC bus capacitor 213, the discharge resistor 216, and the switch unit 218 are connected in parallel. It should be understood that the above embodiments are only used to illustrate feasible implementation methods of the first power unit 104, the second power unit 106, and the third power unit 108, and the present disclosure is not limited in this regard.

According to the above embodiment, different connection buses are connected to the first power unit 104, the second power unit 106, and the third power unit 108. Since a stray parameter of the connection buses is smaller, an AC current passing DC bus capacitors in the first power unit 104, the second power unit 106, and the third power unit 108 is thus reduced. As a result, a number of the DC bus capacitors in the first power unit 104, the second power unit 106, and the third power unit 108 and a volume of the DC bus capacitors in the first power unit 104, the second power unit 106, and the third power unit 108 can be effectively reduced, and the reliability of the power module 102 is increased. In addition, the connection buses connected between the first power unit 104, the second power unit 106, and the third power unit 108 are detachable so as to facilitate installation and maintenance of the first power unit 104, the second power unit 106, and the third power unit 108.

Fig. 3 depicts a block diagram of a power conversion device 300 according to another embodiment of the present disclosure. As shown in Fig. 3, the power conversion device 300 comprises a rectifier module 302, an inverter module 312, and a first interconnection bus 332. The rectifier module 302 comprises the first rectifier power unit 304, the second rectifier power unit 306, the third rectifier power unit 308, a first connection bus 322, and a second connection bus 324. The inverter module 312 comprises the first inverter power unit 314, the second inverter power unit 316, the third inverter power unit 318, a third connection bus 326, and a fourth connection bus 328. Each of he first rectifier power unit 304, the second rectifier power unit 306, the third rectifier power unit 308, the first inverter power unit 314, the second inverter power unit 316, and the third inverter power unit 318 may be implemented by using the single-arm bridge two-level power unit 200A shown in Fig. 2A or the single-arm bridge three-level power unit 200B shown in Fig. 2B, but the present disclosure is not limited in this regard.

The rectifier module 302 is configured to covert an AC power source into a DC power source. The first connection bus 322 is electrically connected to the first rectifier power unit 304 and the second rectifier power unit 306. The second connection bus 324 is electrically connected to the second rectifier power unit 306 and the third rectifier power unit 308. The inverter module 312 is configured to covert a DC power source into an AC power source. The third connection bus 326 is electrically connected to the first inverter power unit 314 and the second inverter power unit 316. The fourth connection bus 328 is electrically connected to the second inverter power unit 316 and the third inverter power unit 318. The first interconnection bus 332 is electrically connected to the rectifier module 302 and the inverter module 312.

In one embodiment, the rectifier module 302 is symmetrically connected to the inverter module 312 through the first interconnection bus 332. For example, the first rectifier power unit 304, the second rectifier power unit 306, and the third rectifier power unit 308 are respectively symmetrical with the first inverter power unit 314 the second inverter power unit 316, and the third inverter power unit 318 geometrically. Hence, when the first interconnection bus 332 electrically connects any of the rectifier power units and the inverter power unit corresponding to it, the rectifier module 302 is symmetrically connected to the inverter module 312. In the present embodiment, the first interconnection bus 332 electrically connects the first rectifier power unit 304 and the first inverter power unit 314. In another embodiment, the first interconnection bus 332 electrically connects the second rectifier power unit 306 and the second inverter power unit 316 or the first interconnection bus 332 electrically connects the third rectifier power unit 308 and the third inverter power unit 318, so that the rectifier module 302 is symmetrically connected to the inverter module 312 through the first interconnection bus 332.

In one embodiment, the first rectifier power unit 304 comprises a first DC bus, the second rectifier power unit 306 comprises a second DC bus, and the third rectifier power unit 308 comprises a third DC bus. The first connection bus 322 is electrically connected to the first DC bus and the second DC bus. The second connection bus 324 is electrically connected to the second DC bus and the third DC bus. In another embodiment, the first inverter power unit 314 comprises a fourth DC bus, the second inverter power unit 316 comprises a fifth DC bus, and the third inverter power unit 318 comprises a sixth DC bus. The third connection bus 326 is electrically connected to the fourth DC bus and the fifth DC bus. The fourth connection bus 328 is electrically connected to the fifth DC bus and the sixth DC bus. In still another embodiment, the first interconnection bus 332 electrically connects the first DC bus and the fourth DC bus. In another embodiment, the first interconnection bus 332 electrically connects the second DC bus and the fifth DC bus or the first interconnection bus 332 electrically connects the third DC bus and the sixth DC bus, so that the rectifier module 302 is symmetrically connected to the inverter module 312 through the first interconnection bus 332.

According to the above embodiment, the power conversion device first utilizes different connection buses to respectively connect the rectifier power units in the rectifier module and the inverter power units in the inverter module, and then utilizes the interconnection bus to connect the rectifier module and the inverter module. In this manner, mutual effects between DC bus capacitors in the rectifier module and DC bus capacitors in the inverter module can be decoupled to decrease a current passing the DC bus capacitors in the rectifier module and the inverter module. As a result, a number of the DC bus capacitors in the rectifier module and the inverter module and a volume of the DC bus capacitors in the rectifier module and the inverter module can be effectively reduced, and reliabilities of the rectifier module and the inverter module are increased.

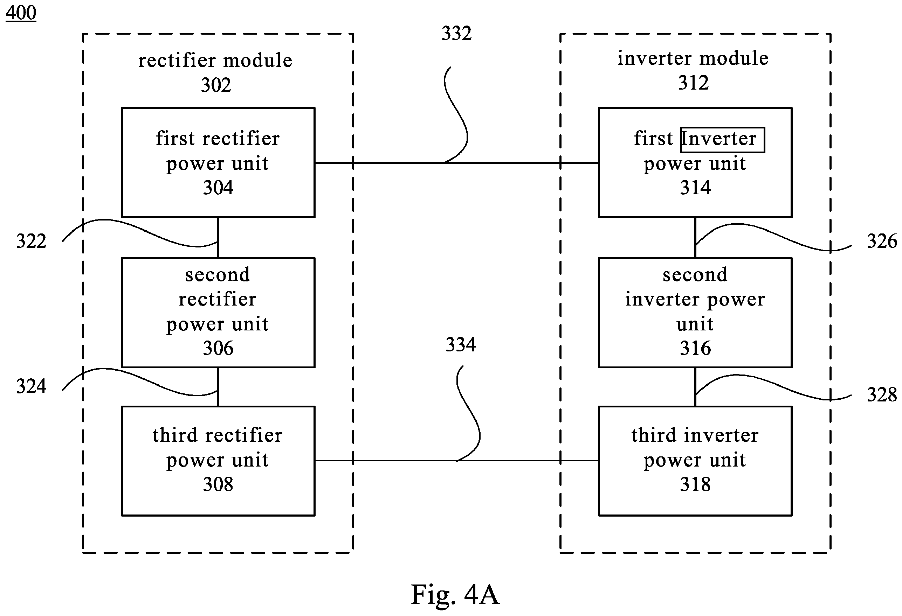

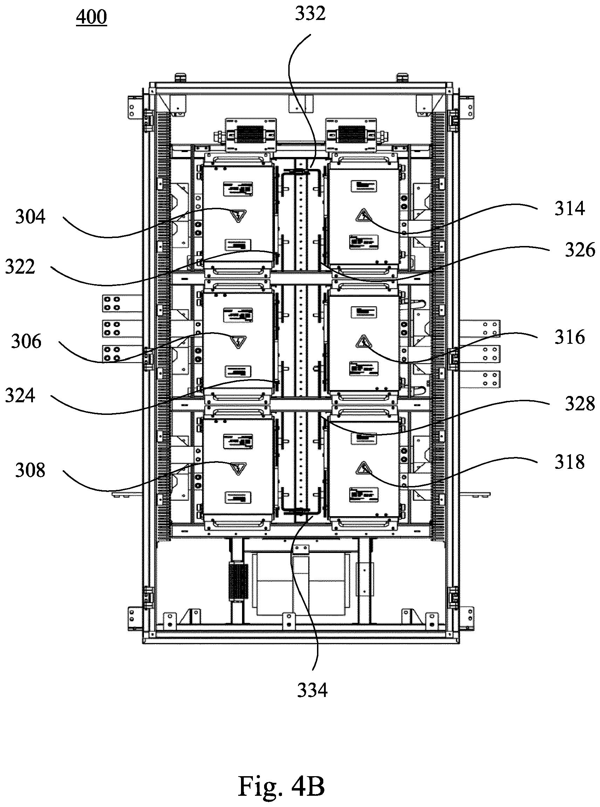

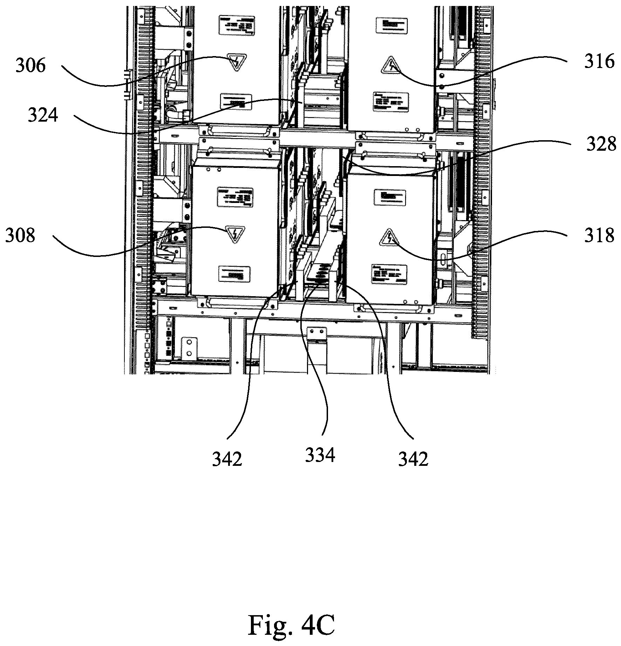

Fig. 4A depicts a block diagram of a power conversion device 400 according to still another embodiment of the present disclosure. As shown in Fig. 4, as compared with the power conversion device 300, the power conversion device 400 further comprises a second interconnection bus 334. The second interconnection bus 334 and the first interconnection bus 332 are disposed in parallel and are electrically connected to the rectifier module 302 and the inverter module 312. For example, the first interconnection bus 332 and the second interconnection bus 334 are respectively disposed between different rectifier power units and inverter power units. Hence, a loop is formed between the rectifier module 302 and the inverter module 312 in the power conversion device 400 through the first interconnection bus 332 and the second interconnection bus 334 so as to balance an AC current passing the DC bus capacitors in the rectifier module 302 and the inverter module 312.

In one embodiment, the rectifier module 302 is symmetrical with the inverter module 312 through the first interconnection bus 332 and the second interconnection bus 334. For example, the first rectifier power unit 304, the second rectifier power unit 306, and the third rectifier power unit 308 are respectively symmetrical with the first inverter power unit 314, the second inverter power unit 316, and the third inverter power unit 318 geometrically. When the first interconnection bus 332 electrically connects any of the rectifier power units and the inverter power unit symmetrical with it, and the second interconnection bus 334 is configured to electrically connect a remaining rectified power unit and an inverter power unit symmetrical with it, the rectifier module 302 is symmetrically connected to the inverter module 312. In the present embodiment, the first interconnection bus 332 is disposed between the first rectifier power unit 304 and the first inverter power unit 314 and the second interconnection bus 334 is disposed between the third rectifier power unit 308 and the third inverter power unit 318, but the present disclosure is not limited in this regard.

Fig. 4B depicts a three-dimensional schematic diagram of the power conversion device 400 in Fig. 4A according to still another embodiment of the present disclosure. In one embodiment, the first rectifier power unit 304 comprises a first DC bus, the second rectifier power unit 306 comprises a second DC bus, and the third rectifier power unit 308 comprises a third DC bus. The first connection bus 322 is electrically connected to the first DC bus and the second DC bus. The second connection bus 324 is electrically connected to the second DC bus and the third DC bus. In another embodiment, the first inverter power unit 314 comprises a fourth DC bus, the second inverter power unit 316 comprises a fifth DC bus, and the third inverter power unit 318 comprises a sixth DC bus. The third connection bus 326 is electrically connected to the fourth DC bus and the fifth DC bus. The fourth connection bus 328 is electrically connected to the fifth DC bus and the sixth DC bus. In still another embodiment, the first interconnection bus 332 electrically connects the first DC bus and the fourth DC bus and the second interconnection bus 334 electrically connects the third DC bus and the sixth DC bus, so that the rectifier module 302 is symmetrically connected to the inverter module 312 through the first interconnection bus 332 and the second interconnection bus 334. However, the present disclosure is not limited in this regard.

According to the above embodiment, the power conversion device first utilizes different connection buses to respectively connect the rectifier power units in the rectifier module and the inverter power units in the inverter module, and then utilizes the first interconnection bus and the second interconnection bus to connect the rectifier module and the inverter module so as to form the loop. The imbalance problem of a current passing the DC bus capacitors in the rectifier module and the inverter module is thus effectively resolved. As a result, a number of the DC bus capacitors in the rectifier module and the inverter module and a volume of the DC bus capacitors in the rectifier module and the inverter module can be effectively reduced, and reliabilities of the rectifier module and the inverter module are increased.

In one embodiment, a magnetic ring is disposed on the interconnection bus to suppress a high-frequency current component on the interconnection bus so as to achieve the effect of reducing an AC current component of the DC bus capacitors in the rectifier module 302 and the inverter module 312. For example, the power conversion device 300 in Fig. 3 further comprises a first magnetic ring, and the first magnetic ring is disposed on the first interconnection bus 322. The power conversion device 400 in Fig. 4A further comprises the first magnetic ring and a second magnetic ring, and the first magnetic ring is disposed on the first interconnection bus 332 and the second magnetic ring is disposed on the second interconnection bus 334. A description is provided with reference to Fig. 4C. For example, one end of the second interconnection bus 334 connecting the third rectifier power unit 308 and another end of the second interconnection bus 334 connecting the third inverter power unit 318 have a second magnetic ring 342. The second magnetic ring 342 is configured to suppress a high-frequency current component on the second interconnection bus 334 so as to achieve the effect of reducing the AC current component of the DC bus capacitors in the rectifier module 302 and the inverter module 312. In another embodiment, one end of the first interconnection bus 332 connecting the first rectifier power unit 304 and another end of the first interconnection bus 332 connecting the first inverter power unit 314 have the first magnetic ring, and the detailed implementation method of the first magnetic ring is similar to that of the embodiment shown in Fig. 4C. It should be understood that the above implementation method of the first magnetic ring and the second magnetic ring is only used for illustration and is not intended to limit the present disclosure. For example, positions and numbers of the first magnetic ring and the second magnetic ring may be flexibly adjusted depending on practical design requirements.

In one embodiment, the rectifier module 302 further comprises a first connection device, a second connection device, and a third connection device. The first connection device is disposed on the first DC bus of the first rectifier power unit 304. The second connection device is disposed on the second DC bus of the second rectifier power unit 306. The third connection device is disposed on the third DC bus of the third rectifier power unit 308. The first connection bus 322 is electrically connected to the first connection device and the second connection device. The second connection bus 324 is electrically connected to the second connection device and the third connection device. In other words, the first rectifier power unit 304, the second rectifier power unit 306, and the third rectifier power unit 308 can be connected to one another through the first connection device, the second connection device, the third connection device, the first connection bus 332, and the second connection bus 324. For example, each of the first connection device, the second connection device, and the third connection device may be a stud or a connecting lug.

In another embodiment, the inverter module 312 further comprises a fourth connection device, a fifth connection device, and a sixth connection device. The fourth connection device is disposed on the fourth DC bus of the first inverter power unit 314. The fifth connection device is disposed on the fifth DC bus of the second inverter power unit 316. The sixth connection device is disposed on the sixth DC bus of the third inverter power unit 318. The third connection bus 326 is electrically connected to the fourth connection device and the fifth connection device. The fourth connection bus 328 is electrically connected to the fifth connection device and the sixth connection device. In other words, the first inverter power unit 314, the second inverter power unit 316, and the third inverter power unit 318 can be connected to one another through the fourth connection device, the fifth connection device, the sixth connection device, the third connection bus 326, and the fifth connection bus 328. For example, each of the fourth connection device, the firth connection device, and the sixth connection device may be a stud or a connecting lug. In addition, detailed implementation and connection methods of the power units and the connection devices may refer to Fig. 1B.

In one embodiment, each of the first rectifier power unit 304, the second rectifier power unit 306, the third rectifier power unit 308, the first inverter power unit 314, the second inverter power unit 316, and the third inverter power unit 318 comprises a single-arm bridge power unit. The single-arm bridge power unit may be a two-level power unit or a multi-level power unit. It should be understood that the above embodiment is only used to illustrate feasible implementation methods of the rectifier power units and the inverter power units, and is not intended to limit the present disclosure. In addition, a detailed implementation method of the single-arm bridge power unit may refer to Fig. 2A and Fig. 2B.

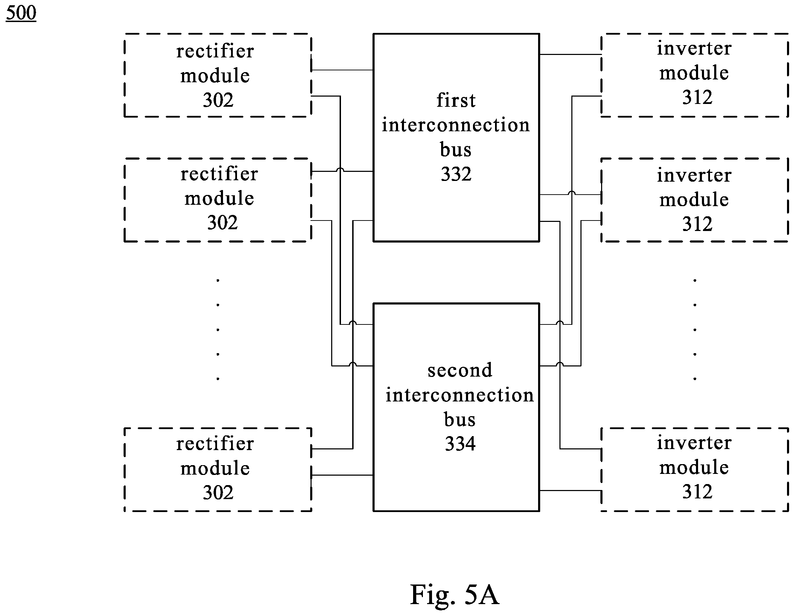

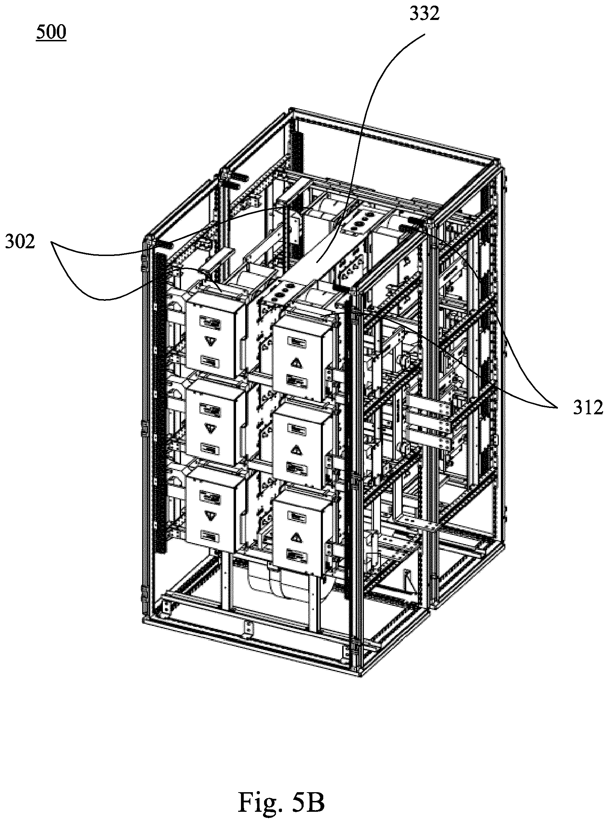

A description is provided with reference to Fig. 5A and Fig. 5B. Fig. 5A depicts a block diagram of a power conversion device according to yet another embodiment of the present disclosure. Fig. 5B depicts a three-dimensional schematic diagram of the power conversion device in Fig. 5A. In one embodiment, a power conversion device 500 comprises a plurality of rectifier modules 302, a plurality of inverter modules 312, and the first interconnection bus 332. The first interconnection bus 332 is electrically connected to each of the rectifier modules 302 and the inverter module 312 corresponding to the each of the rectifier modules 302, so that the rectifier modules 302 are symmetrical with the inverter modules 312 through the first interconnection bus 332. For example, each of the rectifier modules 302 is symmetrical with the corresponding inverter module 312 geometrically. Hence, when the first interconnection bus 332 is electrically connected to each of the rectifier modules 302 and the inverter module 312 symmetrical with the each of the rectifier modules 302, the rectifier modules 302 are symmetrically connected to the corresponding inverter modules 312, respectively. In another embodiment, the first interconnection bus 332 is electrically connected to a first DC bus in each of the rectifier modules 302 and a fourth DC bus in the corresponding inverter module 312.

In one embodiment, the power conversion device 500 further comprises a second interconnection bus 334. The second interconnection bus 334 and the first interconnection bus 332 are disposed in parallel, and are electrically connected to each of the rectifier modules 302 and the inverter module 312 corresponding to the each of the rectifier modules 302, so that the rectifier modules 302 are symmetrical with the inverter modules 312 through the first interconnection bus 332 and the second interconnection bus 334. For example, each of the rectifier modules 302 is symmetrical with the corresponding inverter module 312 geometrically. Hence, when the first interconnection bus 332 and the second interconnection bus 334 are electrically connected to each of the rectifier modules 302 and the inverter module 312 symmetrical with the each of the rectifier modules 302, the rectifier modules 302 are symmetrically connected to the corresponding inverter modules 312, respectively. In another embodiment, the second interconnection bus 334 is electrically connected to a third DC bus in each of the rectifier modules 302 and a sixth DC bus in the corresponding inverter module 312. In another embodiment, magnetic rings may be disposed on the first interconnection bus 332 and/or the second interconnection bus 334. Similarly, positions and numbers of the magnetic rings may be flexibly adjusted depending on practical design requirements.

In the above embodiment, the power conversion device first utilizes different connection buses to respectively connect rectifier power units in the plurality of rectifier modules and inverter power units in the plurality of inverter modules, and then utilizes the interconnection bus(es) to connect the plurality of rectifier modules and the plurality of inverter modules. In this manner, mutual effects between DC bus capacitors in the rectifier modules and DC bus capacitors in the inverter modules can be decoupled to decrease currents passing the DC bus capacitors in the rectifier modules and the inverter modules. As a result, a number of the DC bus capacitors in the rectifier modules and the inverter modules and a volume of the DC bus capacitors in the rectifier modules and the inverter modules can be effectively reduced, and reliabilities of the rectifier modules and the inverter modules are increased.

In summary, the power conversion device disclosed by the present disclosure first utilizes different connection buses to respectively connect the rectifier power units in the rectifier module(s) and the inverter power units in the inverter module(s), and then utilizes the interconnection bus(es) to connect the rectifier module(s) and the inverter module(s), so that the current passing the DC bus capacitors in the rectifier module and the corresponding inverter module is decreased. As a result, the number of the DC bus capacitors in the rectifier module(s) and the inverter module(s) and the volume of the DC bus capacitors in the rectifier module(s) and the inverter module(s) can be effectively reduced, and reliabilities of the rectifier module(s) and the inverter module(s) are increased. In addition, the power conversion device disclosed by the present disclosure further decreases the high-frequency current component on the DC buses through disposing the magnetic ring(s) on the interconnection bus(es) so as to further decrease the current passing the DC bus capacitors.

## Claims

1. A power conversion device (100) comprising:
a rectifier module (302) configured to convert an AC power source into a DC power source, the rectifier module (302) comprising:
a first rectifier power unit (304) with a first DC bus and a first DC capacitor;
a second rectifier power unit (306) with a second DC bus and a second DC capacitor;
a third rectifier power unit (308) with a third DC bus and a third DC capacitor;
a first connection bus (322); and
a second connection bus (324),
wherein the first connection bus (322) is electrically connected to the first rectifier power unit (304) and the second rectifier power unit (306), and the second connection bus (324) is electrically connected to the second rectifier power unit (306) and the third rectifier power unit (308);
an inverter module (312) configured to convert a DC power source into an AC power source, the inverter module (312) comprising:
a first inverter power unit (314) with a fourth DC bus and a fourth DC capacitor;
a second inverter power unit (316) with a fifth DC bus and a fifth DC capacitor;
a third inverter power unit (318) with a sixth DC bus and a sixth DC capacitor;
a third connection bus (326); and
a fourth connection bus (328),
wherein the third connection bus (326) is electrically connected to the first inverter power unit (314) and the second inverter power unit (316), and the fourth connection bus (328) is electrically connected to the second inverter power unit (316) and the third inverter power unit (318),
a first interconnection bus (332) electrically connected to the first DC bus and the fourth DC bus, wherein the rectifier module (302) is symmetrically connected to the inverter module (312) through the first interconnection bus (332); and
a second interconnection bus (334) electrically connected to the third DC bus and the sixth DC bus, wherein the rectifier module (302) is symmetrical with the inverter module (312) through the first interconnection bus (332) and the second interconnection bus (334), and
wherein the rectifier module (302) comprises:
a first connection device (122) disposed on the first DC bus;
a second connection device (124) disposed on the second DC bus; and
a third connection device (126) disposed on the third DC bus;
wherein the inverter module (312) comprises:
a fourth connection device disposed on the fourth DC bus;
a fifth connection device disposed on the fifth DC bus; and
a sixth connection device disposed on the sixth DC bus;
wherein the first connection bus (112, 322) is electrically connected to the first connection device (122) and the second connection device (124), and the second connection bus (114, 324) is electrically connected to the second connection device (124) and the third connection device (126), the third connection bus (326) is electrically connected to the fourth connection device and the fifth connection device, the fourth connection bus (328) is electrically connected to the fifth connection device and the sixth connection device.

2. The power conversion device (100) of claim 1, wherein the first connection bus (322) is electrically connected to the first DC bus and the second DC bus, and the second connection bus (324) is electrically connected to the second DC bus and the third DC bus;
wherein the third connection bus (326) is electrically connected to the fourth DC bus and the fifth DC bus, the fourth connection bus (328) is electrically connected to the fifth DC bus and the sixth DC bus.

3. The power conversion device (100) of claim 1, further comprising:
a first magnetic ring disposed on the first interconnection bus (332).

4. The power conversion device (100) of claim 1, further comprising:
a first magnetic ring disposed on the first interconnection bus (332); and
a second magnetic ring disposed on the second interconnection bus (334).

5. The power conversion device (100) of claim 1, wherein the first interconnection bus (332) is electrically connected to the first connection device (122) and the fourth connection device.

6. The power conversion device (100) of claim 1, wherein the first interconnection bus (332) is electrically connected to the first connection device (122) and the fourth connection device, and the second interconnection bus (334) is electrically connected to the third connection device (126) and the sixth connection device.

7. The power conversion device (100) of claim 1, wherein numbers of rectifier modules (302) and inverter modules (312) are both plural;
wherein the first interconnection bus (332) is electrically connected to the first DC bus of each of the rectifier modules (302) and the fourth DC bus in the inverter module (312) corresponding to the each of the rectifier modules (302), and the rectifier modules (302) are symmetrical with the inverter modules (312) through the first interconnection bus (332).

8. The power conversion device (100) of claim 1, wherein numbers of rectifier modules (302) and inverter modules (312) are both plural;
wherein the first interconnection bus (332) is electrically connected to the first DC bus of each of the rectifier modules (302) and the fourth DC bus in the inverter module (312) corresponding to the each of the rectifier modules (302), the second interconnection bus (334) is electrically connected to the third DC bus of each of the rectifier modules (302) and the sixth DC bus in the inverter module (312) corresponding to the each of the rectifier modules (302), and the rectifier modules (302) are symmetrical with the inverter modules (312) through the first interconnection bus (332) and the second interconnection bus (334).

## Patentansprüche

1. Leistungsumrichtungsvorrichtung (100) umfassend:
ein Gleichrichtermodul (302), das eingerichtet ist, eine Wechselstromquelle in eine Gleichstromquelle umzurichten, wobei das Gleichrichtermodul (302) umfasst:
eine erste Gleichrichter-Leistungseinheit (304) mit einem ersten Gleichstrombus und einem ersten Gleichstromkondensator;
eine zweite Gleichrichter-Leistungseinheit (306) mit einem zweiten Gleichstrombus und einem zweiten Gleichstromkondensator;
eine dritte Gleichrichter-Leistungseinheit (308) mit einem dritten Gleichstrombus und einem dritten Gleichstromkondensator;
einen ersten Verbindungsbus (322); und
einen zweiten Verbindungsbus (324),
wobei der erste Verbindungsbus (322) elektrisch mit der ersten Gleichrichter-Leistungseinheit (304) und der zweiten Gleichrichter-Leistungseinheit (306) verbunden ist, und der zweite Verbindungsbus (324) elektrisch mit der zweiten Gleichrichter-Leistungseinheit (306) und der dritten Gleichrichter-Leistungseinheit (308) verbunden ist;
ein Wechselrichtermodul (312), das eingerichtet ist, eine Gleichstromquelle in eine Wechselstromquelle umzurichten, wobei das Wechselrichtermodul (312) umfasst:
eine erste Wechselrichter-Leistungseinheit (314) mit einem vierten Gleichstrombus und einem vierten Gleichstromkondensator;
eine zweite Wechselrichter-Leistungseinheit (316) mit einem fünften Gleichstrombus und einem fünften Gleichstromkondensator;
eine dritte Wechselrichter-Leistungseinheit (318) mit einem sechsten Gleichstrombus und einem sechsten Gleichstromkondensator;
einen dritten Verbindungsbus (326); und
einen vierten Verbindungsbus (328),
wobei der dritte Verbindungsbus (326) elektrisch mit der ersten Wechselrichter-Leistungseinheit (314) und der zweiten Wechselrichter-Leistungseinheit (316) verbunden ist, und der vierte Verbindungsbus (328) elektrisch mit der zweiten Wechselrichter-Leistungseinheit (316) und der dritten Wechselrichter-Leistungseinheit (318) verbunden ist,
einen ersten Kopplungsbus (332), der elektrisch mit dem ersten Gleichstrombus und dem vierten Gleichstrombus verbunden ist, wobei das Gleichrichtermodul (302) symmetrisch mit dem Wechselrichtermodul (312) durch den ersten Kopplungsbus (332) verbunden ist; und
einen zweiten Kopplungsbus (334), der elektrisch mit dem dritten Gleichstrombus und dem sechsten Gleichstrombus verbunden ist, wobei das Gleichrichtermodul (302) symmetrisch mit dem Wechselrichtermodul (312) durch den ersten Kopplungsbus (332) und den zweiten Kopplungsbus (334) ist, und
wobei das Gleichrichtermodul (302) umfasst:
eine erste Verbindungsvorrichtung (122), die an dem ersten Gleichstrombus angeordnet ist;
eine zweite Verbindungsvorrichtung (124), die an dem zweiten Gleichstrombus angeordnet ist; und
eine dritte Verbindungsvorrichtung (126), die an dem dritten Gleichstrombus angeordnet ist;
wobei das Wechselrichtermodul (312) umfasst:
eine vierte Verbindungsvorrichtung, die an dem vierten Gleichstrombus angeordnet ist;
eine fünfte Verbindungsvorrichtung, die an dem fünften Gleichstrombus angeordnet ist; und
eine sechste Verbindungsvorrichtung, die an dem sechsten Gleichstrombus angeordnet ist;
wobei der erste Verbindungsbus (112,322) elektrisch mit der ersten Verbindungsvorrichtung (122) und der zweiten Verbindungsvorrichtung (124) verbunden ist, und der zweite Verbindungsbus (114,324) elektrisch mit der zweiten Verbindungsvorrichtung (124) und der dritten Verbindungsvorrichtung (126) verbunden ist, wobei der dritte Verbindungsbus (326) elektrisch mit der vierten Verbindungsvorrichtung und der fünften Verbindungsvorrichtung verbunden ist, wobei der vierte Verbindungsbus elektrisch mit der fünften Verbindungsvorrichtung und der sechsten Verbindungsvorrichtung verbunden ist.

2. Leistungsumrichtungsvorrichtung (100) nach Anspruch 1, wobei der erste Verbindungsbus (322) elektrisch mit dem ersten Gleichstrombus und dem zweiten Gleichstrombus verbunden ist, und der zweite Verbindungsbus (324) elektrisch mit dem zweiten Gleichstrombus und dem dritten Gleichstrombus verbunden ist;
wobei der dritte Verbindungsbus (326) elektrisch mit dem vierten Gleichstrombus und dem fünften Gleichstrombus verbunden ist, der vierte Verbindungsbus (328) elektrisch mit dem fünften Gleichstrombus und dem sechsten Gleichstrombus verbunden ist.

3. Leistungsumrichtungsvorrichtung (100) nach Anspruch 1, ferner umfassend:
einen ersten Magnetring, der an dem ersten Kopplungsbus (332) angeordnet ist.

4. Leistungsumrichtungsvorrichtung (100) nach Anspruch 1, ferner umfassend:
einen ersten Magnetring, der an dem ersten Kopplungsbus (332) angeordnet ist; und
einen zweiten Magnetring, der an dem zweiten Kopplungsbus (334) angeordnet ist.

5. Leistungsumrichtungsvorrichtung (100) nach Anspruch 1, wobei der erste Kopplungsbus (332) elektrisch mit der ersten Verbindungsvorrichtung (122) und der vierten Verbindungsvorrichtung verbunden ist.

6. Leistungsumrichtungsvorrichtung (100) nach Anspruch 1, wobei der erste Kopplungsbus (332) elektrisch mit der ersten Verbindungsvorrichtung (122) und der vierten Verbindungsvorrichtung verbunden ist, und der zweite Kopplungsbus (334) elektrisch mit der dritten Verbindungsvorrichtung (126) und der sechsten Verbindungsvorrichtung verbunden ist.

7. Leistungsumrichtungsvorrichtung (100) nach Anspruch 1, wobei die Anzahlen der Gleichrichtermodule (302) und der Wechselrichtermodule (312) beide eine Mehrzahl sind;
wobei der erste Kopplungsbus (332) elektrisch verbunden ist mit dem ersten Gleichstrombus jedes der Gleichrichtermodule (302) und der vierte Gleichstrombus in dem Wechselrichtermodul (312) der mit dem jeweiligen Gleichrichtermodul (302) übereinstimmt, und die Gleichrichtermodule (302) symmetrisch mit dem Wechselrichtermodul (312) durch den ersten Kopplungsbus (332) sind.

8. Leistungsumrichtungsvorrichtung (100) nach Anspruch 1, wobei die Anzahlen der Gleichrichtermodule (302) und der Wechselrichtermodule (312) beide eine Mehrzahl sind;
wobei der erste Kopplungsbus (332) elektrisch verbunden ist mit dem ersten Gleichstrombus jedes der Gleichrichtermodule (302) und der vierte Gleichstrombus in dem Wechselrichtermodul (312) der mit dem jeweiligen Gleichrichtermodul (302) übereinstimmt, der zweite Kopplungsbus (334) elektrisch verbunden ist mit dem dritten Gleichstrombus jedes der Gleichrichtermodule (302) und der sechste Gleichstrombus im Gleichrichtermodul (312) der mit dem jeweiligen der Gleichrichtermodule (302) übereinstimmt, und die Gleichrichtermodule (302) symmetrisch mit dem Invertermodul (312) durch den ersten Kopplungsbus (332) und dem zweiten Kopplungsbus (334) sind.

## Revendications

1. Dispositif de conversion d'alimentation électrique (100) comprenant :
un module redresseur (302) configuré pour convertir une source d'alimentation en courant alternatif, CA, en une source d'alimentation en courant continu, CC, le module redresseur (302) comprenant :
une première unité d'alimentation électrique de redresseur (304) avec un premier bus CC et un premier condensateur CC ;
une deuxième unité d'alimentation électrique de redresseur (306) avec un deuxième bus CC et un deuxième condensateur CC ;
une troisième unité d'alimentation électrique de redresseur (308) avec un troisième bus CC et un troisième condensateur CC ;
un premier bus de connexion (322) ; et
un deuxième bus de connexion (324),
dans lequel le premier bus de connexion (322) est connecté électriquement à la première unité d'alimentation électrique de redresseur (304) et à la deuxième unité d'alimentation électrique de redresseur (306), et le deuxième bus de connexion (324) est connecté électriquement à la deuxième unité d'alimentation électrique de redresseur (306) et à la troisième unité d'alimentation électrique de redresseur (308) ;
un module onduleur (312) configuré pour convertir une source d'alimentation électrique CC en une source d'alimentation électrique CA, le module onduleur (312) comprenant :
une première unité d'alimentation électrique d'onduleur (314) avec un quatrième bus CC et un quatrième condensateur CC ;
une deuxième unité d'alimentation électrique d'onduleur (316) avec un cinquième bus CC et un cinquième condensateur CC ;
une troisième unité d'alimentation électrique d'onduleur (318) avec un sixième bus CC et un sixième condensateur CC ;
un troisième bus de connexion (326) ; et
un quatrième bus de connexion (328),
dans lequel le troisième bus de connexion (326) est connecté électriquement à la première unité d'alimentation électrique d'onduleur (314) et à la deuxième unité d'alimentation électrique d'onduleur (316), et le quatrième bus de connexion (328) est connecté électriquement à la deuxième unité d'alimentation électrique d'onduleur (316) et à la troisième unité d'alimentation électrique à onduleur (318),
un premier bus d'interconnexion (332) connecté électriquement au premier bus CC et au quatrième bus CC, dans lequel le module redresseur (302) est connecté symétriquement au module onduleur (312) via le premier bus d'interconnexion (332) ; et
un deuxième bus d'interconnexion (334) connecté électriquement au troisième bus CC et au sixième bus CC, dans lequel le module redresseur (302) est symétrique avec le module onduleur (312) via le premier bus d'interconnexion (332) et le deuxième bus d'interconnexion (334), et
dans lequel le module redresseur (302) comprend :
un premier dispositif de connexion (122) disposé sur le premier bus CC ;
un deuxième dispositif de connexion (124) disposé sur le deuxième bus CC ; et
un troisième dispositif de connexion (126) disposé sur le troisième bus CC;
dans lequel le module onduleur (312) comprend :
un quatrième dispositif de connexion disposé sur le quatrième bus CC ;
un cinquième dispositif de connexion disposé sur le cinquième bus CC ; et
un sixième dispositif de connexion disposé sur le sixième bus CC ;
dans lequel le premier bus de connexion (112, 322) est connecté électriquement au premier dispositif de connexion (122) et au deuxième dispositif de connexion (124), et le deuxième bus de connexion (114, 324) est connecté électriquement au deuxième dispositif de connexion (124) et au troisième dispositif de connexion (126), le troisième bus de connexion (326) est connecté électriquement au quatrième dispositif de connexion et au cinquième dispositif de connexion, le quatrième bus de connexion (328) est connecté électriquement au cinquième dispositif de connexion et à la sixième connexion dispositif.

2. Dispositif de conversion d'alimentation électrique (100) selon la revendication 1, dans lequel le premier bus de connexion (322) est connecté électriquement au premier bus CC et au deuxième bus CC, et le deuxième bus de connexion (324) est connecté électriquement au deuxième bus CC et au troisième bus CC ;
dans lequel le troisième bus de connexion (326) est connecté électriquement au quatrième bus CC et au cinquième bus CC, le quatrième bus de connexion (328) est connecté électriquement au cinquième bus CC et au sixième bus CC.

3. Dispositif de conversion d'alimentation électrique (100) selon la revendication 1, comprenant en outre :
un premier anneau magnétique disposé sur le premier bus d'interconnexion (332).

4. Dispositif de conversion d'alimentation électrique (100) selon la revendication 1, comprenant en outre :
un premier anneau magnétique disposé sur le premier bus d'interconnexion (332) ; et
un second anneau magnétique disposé sur le deuxième bus d'interconnexion (334).

5. Dispositif de conversion d'alimentation électrique (100) selon la revendication 1, dans lequel le premier bus d'interconnexion (332) est connecté électriquement au premier dispositif de connexion (122) et au quatrième dispositif de connexion.

6. Dispositif de conversion d'alimentation électrique (100) selon la revendication 1, dans lequel le premier bus d'interconnexion (332) est connecté électriquement au premier dispositif de connexion (122) et au quatrième dispositif de connexion, et le deuxième bus d'interconnexion (334) est connecté électriquement au troisième dispositif de connexion (126) et au sixième dispositif de connexion.

7. Dispositif de conversion d'alimentation électrique (100) selon la revendication 1, dans lequel les nombres de modules redresseurs (302) et de modules onduleurs (312) sont tous les deux pluriels ;
dans lequel le premier bus d'interconnexion (332) est connecté électriquement au premier bus CC de chacun des modules redresseurs (302) et au quatrième bus CC dans le module onduleur (312) correspondant à chacun des modules redresseurs (302), et les modules redresseurs (302) sont symétriques avec les modules onduleurs (312) via le premier bus d'interconnexion (332).

8. Dispositif de conversion d'alimentation électrique (100) selon la revendication 1, dans lequel les nombres de modules redresseurs (302) et de modules onduleurs (312) sont tous les deux pluriels ;
dans lequel le premier bus d'interconnexion (332) est connecté électriquement au premier bus CC de chacun des modules redresseurs (302) et au quatrième bus CC dans le module onduleur (312) correspondant à chacun des modules redresseurs (302), le deuxième bus d'interconnexion (334) est connecté électriquement au troisième bus CC de chacun des modules redresseurs (302) et au sixième bus CC dans le module onduleur (312) correspondant à chacun des modules redresseurs (302), et les modules redresseurs (302) sont symétriques avec les modules onduleurs (312) via le premier bus d'interconnexion (332) et le deuxième bus d'interconnexion (334).
